# EUROPEAN PATENT SPECIFICATION

(11) **EP 4 462 477 B1**
(45) Date of publication and mention of the grant of the patent: **25.11.2026**
(21) Application number: 23172329.7
(22) Date of filing: 09.05.2023
(51) Int. Cl.: H10W 40/30, G06N 10/40, H05K 9/00

(54) **SUPERCONDUCTING MAGNETIC SHIELD FOR ION TRAP**
SUPRALEITENDE MAGNETISCHE ABSCHIRMUNG FÜR IONENFALLE
BLINDAGE MAGNÉTIQUE SUPRACONDUCTEUR POUR PIÈGE À IONS

(43) Date of publication of application: 13.11.2024
(73) Proprietor: Infineon Technologies Austria AG, 9500 Villach (AT)
(72) Inventor: BRANDL, Matthias, 85614 Kirchseeon (DE)
(74) Representative: Lambsdorff & Lange Patentanwälte Partnerschaft mbB

(56) References cited:
- EP-A1- 3 792 956
- INFINEON TECHNOLOGIES AG: "Trapped Ions - Infineon Technologies", 12 March 2022 (2022-03-12), pages 1 - 8, XP093090118, Retrieved from the Internet <URL:https://www.infineon.com/cms/en/product/promopages/trapped-ions/> [retrieved on 20231010]

## Description

### Technical Field

This disclosure relates generally to the field of ion traps, and in particular to ion traps for quantum computing to be installed in a cryogenic environment.

### Background

Trapped ions are one of the most promising candidates for use as qubits (quantum bits) in quantum computers since they can be trapped with long lifetimes in a scalable array by virtue of electromagnetic fields.

Ion trap devices may be operated in a cryogenic environment. To that end, an ion trap device is mechanically and thermally coupled to a cryostat head. Typically, a trap socket may be used to mount the ion trap device to the cryostat head.

In many applications, the ion trap device may be sensitive to environmental disturbances, such as, e.g., external magnetic fields. In such cases, it is desirable to keep external disturbances low and/or to create controllable conditions in the ion trap region.

Document EP 3 792 956 A1 relates to devices, systems, and methods for an enclosure for ion trapping devices. Document Infineon Technologies AG: "Trapped Ions - Infineon Technologies", 12 March 2022 (2022-03-12), pages 1-8, XP93090118, Retrieved from the Internet:
URL:https://www.infineon.com/cms/en/product/promopages/trapped-ions/ relates to trapped ion quantum computing.

### Summary

According to an aspect of the disclosure, a cryogenic system includes an ion trap device configured to be mounted on a trap socket. A magnetic radiation shield of a superconducting material surrounds an ion trap region of the ion trap device, wherein the magnetic radiation shield forms part of the ion trap device and/or the trap socket. A magnet is enclosed by the magnetic radiation shield.

According to another aspect of the disclosure, a method of shielding an ion trap device from magnetic radiation comprises mounting the ion trap device on a trap socket. A magnetic radiation shield of a superconducting material surrounding an ion trap region of the ion trap device is provided, wherein the magnetic radiation shield forms part of the ion trap device and/or the trap socket. A magnet is provided, wherein the magnet is enclosed by the magnetic radiation shield. The ion trap device is cooled below a temperature at which the superconducting material becomes superconductive.

### Brief description of the drawings

Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a schematic cross-sectional view of a trap socket loaded with an ion trap device, a magnetic radiation shield and a magnet enclosed by the magnetic radiation shield.
Figure 2 is a schematic conceptual view illustrating a cryogenic system in which the magnetic radiation shield forms part of the trap socket.
Figure 3 is a schematic conceptual view illustrating a cryogenic system in which the magnetic radiation shield forms part of the trap socket and of the ion trap device.
Figure 4 is a schematic conceptual view illustrating a cryogenic system in which the magnetic radiation shield forms part of the ion trap device.
Figure 5 is a schematic cross-sectional view of an exemplary cryogenic system in accordance with the conceptual view of Figure 2.
Figure 6 is a schematic cross-sectional view of an exemplary cryogenic system in accordance with the conceptual view of Figure 3.
Figure 7 is a schematic view illustrating a laser light beam passing through an opening in the magnetic radiation shield.
Figure 8 is a schematic view illustrating magnetic field lines entering the interior of the magnetic radiation shield through an opening in the magnetic radiation shield.
Figure 9 illustrates a first example of a passage for electrical transmission passing through a magnetic radiation shield.
Figure 10 illustrates a second example of a passage for electrical transmission passing through a magnetic radiation shield.
Figure 11 illustrates a third example of a passage for electrical transmission passing through a multi-layer magnetic radiation shield.
Figure 12 illustrates an example of a passage for optical transmission passing through a multi-layer magnetic radiation shield.
Figure 13 is a flowchart illustrating exemplary stages of a method of shielding an ion trap device from magnetic radiation.

### Detailed description

It is to be understood that the features of the various exemplary embodiments and examples described herein may be combined with each other unless specifically noted otherwise.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

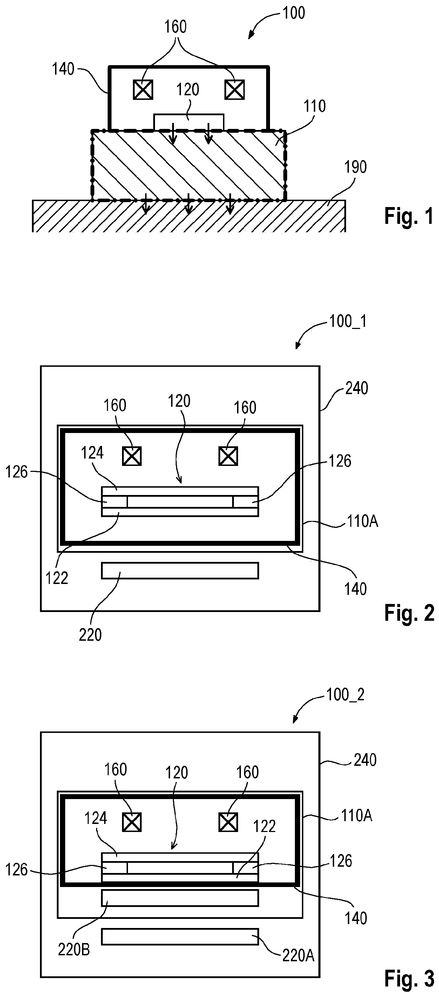

Figure 1 illustrates an example of a cryogenic system 100. The cryogenic system 100 includes an ion trap device 120 and a magnetic radiation shield 140 of a superconducting material surrounding an ion trap region of the ion trap device 120. A magnet 160 is enclosed by the magnetic radiation shield 140.

The cryogenic system 100 is used in a cryogenic environment. That is, at least during operation, the ion trap device 120 is mounted on a trap socket 110, and the trap socket 110 is mounted on a cryogenic head 190 of a cryostat (not shown). The cryogenic head 190 of the cryostat forms a cooled mounting platform of the cryostat.

The trap socket 110 may be configured to allow safe and fast ion trap device changes for short learning cycles in further development. Typically, ion trap device changes are complicated because the ion trap device 120 often needs to be installed or removed upright or overhead, usually in very confined spaces.

Further, the trap socket 110 may be configured to effectively dissipate heat generated in the ion trap device 120 during operation. To that end, the ion trap device 120 may be attached (e.g., clamped) to the trap socket 110 in a manner that provides high thermal conductivity between the ion trap device 120 and the trap socket 110.

The cryogenic system 100 described herein may or may not include the trap socket 110. The magnetic radiation shield 140 forms part of the ion trap device 120 and/or the trap socket 110. If the magnetic radiation shield 140 forms part of the ion trap device 120 and does not form part of the trap socket 110, the trap socket 110 is not necessarily part of the cryogenic system 100. Otherwise, if at least a part of the magnetic radiation shield 140 forms a part of the trap socket 110, the cryogenic system 100 includes the trap socket 110.

Differently stated, the disclosure relates to an ion trap device 120 which is enclosed by a "local" magnetic radiation shield 140, i.e. a magnetic radiation shield 140 which may not be part of the cryostat (not shown) including the cryogenic head 190. Rather, as the magnetic radiation shield 140 forms part of the ion trap device 120 and/or the trap socket 110, the magnetic radiation shield 140 can be small in size. Further, as the magnetic radiation shield 140 forms part of the ion trap device 120 and/or the trap socket 110, the magnetic radiation shield 140 is typically removed from the cryostat together with the trap socket 110 and the ion trap device 120 when replacing the ion trap device 120. Typically, ion trap device changes (removal of an ion trap device 120 from the cryostat and installation of a new ion trap device 120 in the cryostat) are carried out by disassembling the trap socket 110 along with the ion trap device 120 mounted thereon from the stationary cryogenic head 190 of the cryostat.

In some examples the magnetic radiation shield 140 may form part of the ion trap device 120 and/or the trap socket 110 by being a detachable part, which is pre-assembled with the ion trap device 120 and/or the trap socket 110. In other examples the magnetic radiation shield 140 may form part of the ion trap device 120 and/or the trap socket 110 by including or representing an integral part (such as, e.g., a surface coating or an internal ("buried") layer) of the ion trap device 120 and/or the trap socket 110.

As a variety of different designs of the magnetic radiation shield 140 can be used, the magnetic radiation shield 140 in Figure 1 is schematically shown to either surround only the ion trap device 120 (solid line and dashed line) or to surround the ion trap device 120 and the trap socket 110 (solid line and dashed-dotted line), for example.

In general, the ion trap region of the ion trap device 120 may be surrounded on all sides by the magnetic radiation shield 140. For example, the magnetic radiation shield 140 may be a closed shield, with the exception of passages or openings for electrical and/or optical transmissions, as described in more detail further below.

The superconducting magnetic radiation shield 140 uses the Meissner-Ochsenfeld effect to eliminate any external magnetic field noise at the ion trap region of the ion trap device 120. Once the superconducting magnetic radiation shield 140 is in the superconducting state, no external magnetic field noise (magnetic field fluctuations) can enter the interior of the superconducting magnetic radiation shield 140, resulting in highly temporally stable magnetic field conditions in the interior.

In other words, a superconductor freezes a magnetic field at its surface when it becomes superconducting. Therefore, a hollow superconductor is a suitable (also referred to as perfect) magnetic shield against external field fluctuations.

For example, the earth's magnetic field is about 0.5 Gauss (50 µT). During a solar eruption, the earth's magnetic field may change by more than 35 pT.

A Zeeman qubit may have a frequency shift of 28 GHz/T = 2.8 MHz/Gauss, for example. For a decoherence time equal to or greater than 1 s (without spin echo and/or dynamic decoupling), a magnetic field stability better than 35 pT (or 350 nGauss) is required. Thus, without a magnetic radiation shield, the decoherence time could be affected by changes in the external magnetic field, e.g., by the variations in the earth's magnetic field. On the other hand, such magnetic field fluctuations are shielded if a magnetic shield such as magnetic radiation shield 140 is provided.

If a hollow superconductor (as represented by the magnetic radiation shield 140) is cooled down in a zero magnetic field environment and becomes superconducting, no magnetic fields (below the critical magnetic field) at all can enter this hollow superconductor.

However, if an external magnetic field is present during the cool-down (e.g., the earth's magnetic field or a magnetic field in the laboratory), uncontrollable effects may occur. Since the superconducting magnetic radiation shield 140 does not become superconducting everywhere at the same time, local magnetic fields can become frozen-in. Such frozen-in magnetic fields may even have higher amplitudes than the original external fields and can point in any direction.

Due to the magnetic radiation shield 140, this frozen-in magnetic field is constant over time at the position of the ion. The magnetic field noise of the environment, e.g., the laboratory or the change in the earth's magnetic field during a solar storm, cannot enter the interior of the magnetic radiation shield 140 and therefore will not change the qubit frequencies and cause decoherence, which otherwise may limit quantum computing.

Further, the magnet 160 enclosed by the magnetic radiation shield 140 may be used to generate a reproducible magnetic field inside the magnetic radiation shield 140 at the ion trap region that is used for operation of the ion trap device 120. The magnetic field at the ion trap region may, e.g., be used to remove the degeneracy of individual Zeeman states.

Moreover, the superconducting magnetic radiation shield 140 may be cooled down in an (ideally) zero magnetic field environment.

Figure 2 is a schematic conceptional view illustrating an exemplary cryogenic system 100_1. Line 110A represents the extent of the trap socket 110. The ion trap device 120 is surrounded from all sides by the magnetic radiation shield 140. The magnet 160 is also enclosed by the magnetic radiation shield 140. Figure 2 conceptionally illustrates the case where the magnetic radiation shield 140 forms part of the trap socket 110 and does not form part of the ion trap device 120.

Here and in all other examples, the ion trap device 120 may include a first substrate 122 and, optionally, at least a second substrate 124. The ion trap region of the ion trap device 120 may be located in a space above the first substrate 122 and, if existing, below the second substrate 124.

The ion trap device 120 may, e.g., be a micro-fabricated ion trap device 120 of any suitable design. The first and second substrates 122, 124 may, e.g., comprise or be formed of a semiconductor material or a dielectric material, e.g., glass or sapphire. The ion trap device 120 may include ion trap electrodes (not shown) disposed on the opposing surfaces of the first substrate 122 and (optionally) the second substrate 124. The electrodes may be formed by micro-fabrication techniques (e.g., metal deposition, lithography, etc.).

The first and second substrates 122, 124 may be spaced apart by spacers 126. The spacers 126 may be provided with lateral openings to allow laser light be introduced into the ion trap device 120 and propagating to the ion trap region. The first substrate 122 and, if existing, the second substrate 124 and the spacers 126 may form a so-called ion trap chip.

The ion trap device 120 may further include a device carrier (not shown in Figure 2). The device carrier may, e.g., include a printed circuit board (PCB) on which the first substrate 122 (or, in other words, the ion trap chip) is mounted.

The magnet 160 may, e.g., be a permanent magnet. In other examples the magnet 160 may include an electrical coil. The electrical coil may, e.g., be a superconducting electrical coil.

As the ion trap device 120 and the magnet 160 (if including an electrical coil) need to be controlled and/or energized, the magnetic radiation shield 140 may be provided with passages (ports) for electrical transmission. In the example shown in Figure 2, active electronics 220 to control the ion trap device 120 may be located outside the magnetic radiation shield 140. When the active electronics 220 is located outside the magnetic radiation shield 140, the magnetic field of the electronics 220 is shielded. The active electronics 220 may be mounted on the trap socket 110 or, as shown in Figure 2, may not be mounted on the trap socket 110.

Figure 2 further illustrates the extent of an inner heat shield 240, which is typically a part of the cryostat. That is, if the trap socket 110 is removed together with the ion trap device 120 from the cryostat, the inner heat shield 240 has to be opened and remains at the cryostat.

Figure 3 illustrates a cryogenic system 100_2. The cryogenic system 100_2 may distinguish from the cryogenic system 100_1 in that the magnetic radiation shield 140 forms part of the ion trap device 120 and of the trap socket 110. For example, a portion of the magnetic radiation shield 140 may be pre-assembled or integral with the trap socket 110 (line 110A indicates the extent of the trap socket 110), while another portion or the residual portion of the magnetic radiation shield 140 may be pre-assembled or integral with the ion trap device 120.

Figure 3 covers a high degree of design variability of the magnetic radiation shield 140. For example, as schematically indicated in Figure 3, the magnetic radiation shield 140 may partly cover the bottom of the first substrate 120. For example, at least in this region, the magnetic radiation shield 140 may be provided by a coating of a superconducting material (e.g., aluminum, niobium, tantalum) deposited on the backside of the ion trap device 120 (or, more specifically, on the backside of the first substrate 122).

Other portions of the magnetic radiation shield 140 may be formed as a layer of superconducting material disposed on one or more parts of the trap socket 110. For example, the layer may be provided by coatings of inner or outer surfaces of parts of the trap socket 110.

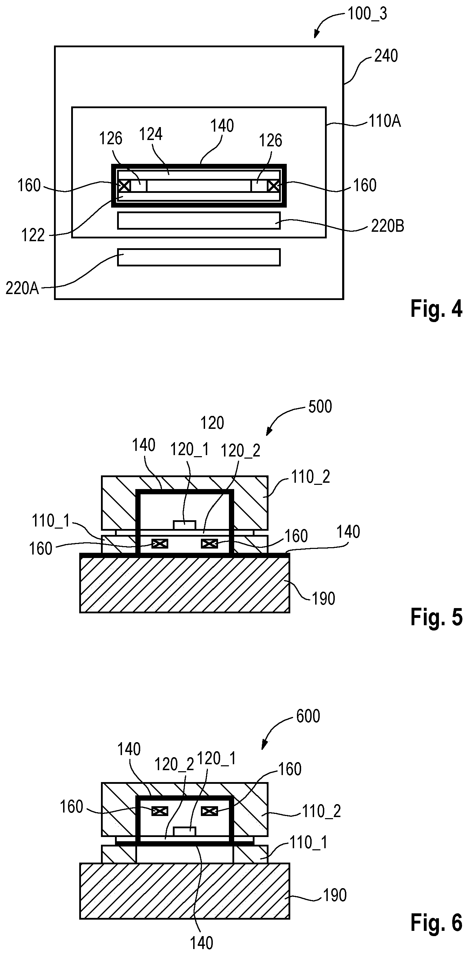

For example, as will be described in more detail further below, the trap socket 110 may include a frame (not shown in Figure 3) surrounding the ion trap device 120 and a cover (not shown in Figure 3) covering the ion trap device 120 and being assembled with the frame. The portion of the magnetic radiation shield 140 which does not form part of the ion trap device 120 may, e.g., be implemented by a superconducting material coating on the inner and/or the outer surfaces of the frame and/or the cover of the trap socket 110 (cf., Figures 5, 6).

Further, Figure 3 illustrates an example in which the active electronics 220 of Figure 2 is split in at least two parts 220A, 220B, wherein active electronic part 220A is external of the trap socket 110 (e.g., not mounted on the trap socket 110), while active electronic part 220B is internal with reference to the line of extent 110A of the trap socket 110 (e.g., mounted on the trap socket 110).

The active electronics 220, 220A, 220B may comprise digital-to-analog converters (DACs) providing control signals for the trap electrodes (not shown). The entire active electronics 220, 220A, 220B, for example at least all DACs, may be located outside of the magnetic radiation shield 140 to avoid interference.

In Figure 3 (and also in the example shown in Figure 2), the magnetic radiation shield 140 may enclose a first portion of the trap socket 110 and exclude a second portion of the trap socket 110. The second portion may be illustrated by being inside the line of extent 110A of the trap socket 110 but outside the magnetic radiation shield 140. The second portion may, e.g., be used for mounting at least a part of the active electronics 220B.

Figure 4 illustrates a cryogenic system 100_3. The cryogenic system 100_3 distinguishes from the cryogenic systems 100_1 and 100_2 in that the magnetic radiation shield 140 forms part of the ion trap device 120 and does not form part of the trap socket 110. In other words, the magnetic radiation shield 140 remains on the ion trap device 120 when the ion trap device 120 is removed from the trap socket 110.

Further, in this example and optionally in the examples described above, the magnet 160 is part of the ion trap device 120.

In all examples, the ion trap device 120 may, e.g., be a micro-fabricated two-dimensional (2D - without second substrate 124) or three-dimensional (3D - with second substrate 124) ion trap. Further, in all examples, the ion trap device 120 may, e.g., be a Paul trap. The magnetic radiation shield 140 may be implemented, for example, partially or completely by a surface coating and/or by an integrated layer of the first substrate 122 and, if present, the second substrate 124 and/or the spacer 126.

In other examples in which the magnetic radiation shield 140 is not integrally formed with the ion trap device 120, the magnetic radiation shield 140 may be formed by, for example, a removable housing of the ion trap device 120 that is assembled with the ion trap device 120. When the ion trap device 120 is removed from the trap socket 110, the magnetic radiation shield 140 (which may, e.g., be implemented by a coating, an integral layer or a pre-assembled housing of the ion trap device 120) is removed together with the ion trap device 120.

Figures 5 and 6 illustrate exemplary implementations of cryogenic systems 500, 600. The cryogenic system 500 is a specific, non-limiting example of the cryogenic system 100_1 of Figure 2, and the cryogenic system 600 is a specific, non-limiting example of the cryogenic system 100_2 of Figure 3. Features of cryogenic systems 500, 600 may be selectively combined with features of cryogenic systems 100_1 and 100_2, respectively.

In Figures 5 and 6 the trap socket 110 may include at least two parts, namely a frame 110_1 and a cover 110_2. The ion trap device 120 may include an ion trap chip 120_1 and a device carrier 120_2 on which the ion trap chip 120_1 is mounted. The ion trap chip 120_1 may be designed as described above in connection with Figures 2 to 4, for example.

In cryogenic systems 500 and 600 the ion trap device 120 is mounted on the trap socket 120 via the device carrier 120_2. For example, the device carrier 120_2 is disposed between opposing surfaces of the frame 110_1 and the cover 110_2. The cover 110_2 may be configured to exert a compressive force on a front side of the device carrier 120_2 by which a rear side of the device carrier 120_2 is pressed against the frame 110_1. That way, when the cover 110_2 is assembled with the frame 110_1, heat generated in the ion trap chip 120_1 may be effectively removed via the device carrier 120_2 from the ion trap device 120 and transferred by the frame 110_1 and/or the cover 110_2 to the cryogenic head 190.

In cryogenic system 500 the inner surface of the frame 110_1, the inner surface of the cover 110_2 and, e.g., a top surface of the cryogenic head 190 may be covered by a layer forming the magnetic radiation shield 140. In other examples, other surfaces of the frame 110_1 and/or of the cover 110_2 such as, e.g., outer surfaces thereof, may be covered by a layer forming the magnetic radiation shield 140. Further, while in Figure 5 a portion of the magnetic radiation shield 140 is, e.g., formed as a layer on the cryogenic head 190, in other examples the entire magnetic radiation shield 140 may form part of the trap socket 110. In this case, if the trap socket 110 is removed from the cryostat, the entire magnetic radiation shield 140 is removed together with the trap socket 110 (and the ion trap device 120 assembled with the trap socket 110).

Cryogenic system 600 illustrates an example in which the magnetic radiation shield 140 is partly disposed on the trap socket 110 and partly on the ion trap device 120. In the specific design shown in Figure 6, an inner surface of the cover 110_2 is coated with a layer forming the trap socket-based portion of the magnetic radiation shield 140, while a bottom surface of the device carrier 120_2 is coated with a layer forming the ion trap device-based portion of the magnetic radiation shield 140, for example. As mentioned above, other surfaces of the trap socket 110 and the ion trap device 120 may be used for being coated with portions of the magnetic radiation shield 140. Generally speaking, the magnetic radiation shield 140 may include or consist of portions formed on the trap socket 110 (e.g., the frame 110_1 and/or the cover 110_2) and/or on the ion trap device 120 and, optionally, on the cryogenic head 190.

The magnetic radiation shield 140 (as shown in Figures 1 to 5) may surround the ion trap region of the ion trap device 120 from all sides in the circumferential direction. However, passages for electrical transmission and/or passages for optical transmission and/or for thermal transmission through the magnetic radiation shield 140 may be provided.

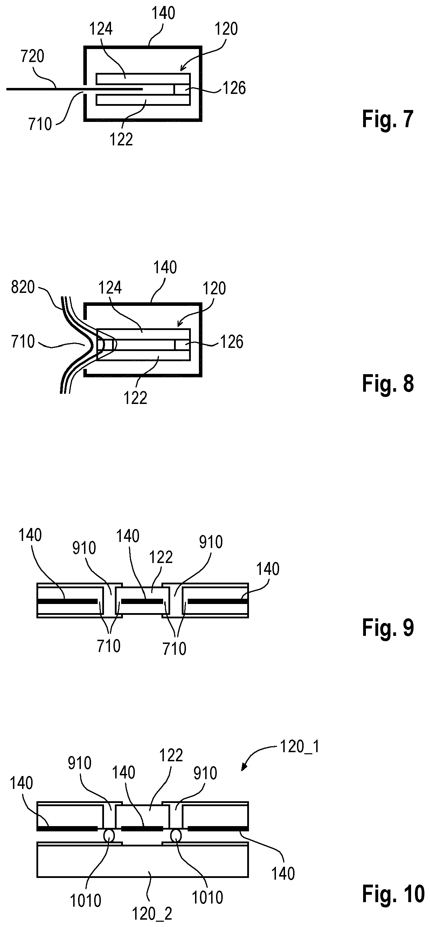

Figure 7 schematically illustrates an opening 710 in the magnetic radiation shield 140. The opening 710 forms a passage for optical transmission into the interior of the magnetic radiation shield 140. More specifically, the opening 710 may be configured to pass a laser light beam 720 into the interior of the magnetic radiation shield 140 to reach the ion trap region of the ion trap device 120.

In other examples, the opening 710 may be configured to form a passage for electrical transmission through the magnetic radiation shield 140. Similar to the laser light beam 720, for example, one or more electrical conductors may pass through the opening 710 to energize and/or control the ion trap device 120. The electrical conductors may, e.g., be made of a superconducting material, e.g. a superconducting metal material.

In other examples, the opening 710 may be configured to form a passage for thermal transmission through the magnetic radiation shield 140. Similar to the laser light beam 720, for example, one or more thermal conductors (e.g., made of a non-superconducting metal material) may pass through the opening 710 to thermally anchor the ion trap device 120 to the cryostat. Such thermal conductors may, e.g., not be used for electrical transmission, solely for thermal anchoring. Non-superconducting metal materials typically have a higher thermal conductivity than superconducting metal materials.

Figure 8 schematically illustrates magnetic field lines 820 entering the interior of the magnetic radiation shield 140 through such an opening 710 in the magnetic radiation shield 140. The larger the opening 710, the less effective is the magnetic radiation shield 140. In other words, any opening 710 should be designed to allow as little magnetic field as possible to penetrate.

Referring to Figure 9, the first substrate 122 (or any other part or structure supporting or including a portion of the magnetic radiation shield 140) may include electrical vias 910 passing through openings 710 in the magnetic radiation shield 140. In Figure 9 the magnetic radiation shield 140 is, for example, implemented by an internal layer of the first substrate 122.

Referring to Figure 10, the electrical vias 910 through the opening 710 of the magnetic radiation shield 140 may include bonding or bumping portions 1010. The bonding or bumping portions 1010 (e.g., of solder, conductive adhesive, etc.) may be configured to electrically connect circuitry of the ion trap chip 120_1 to the device carrier 120_2. The device carrier 120_2 may, e.g., be a PCB or any other substrate or wafer, for example. The magnetic radiation shield 140 may be formed, at least partly, by a layer or coating covering, e.g., an outer surface of the first substrate 122 of the ion trap chip 120_1.

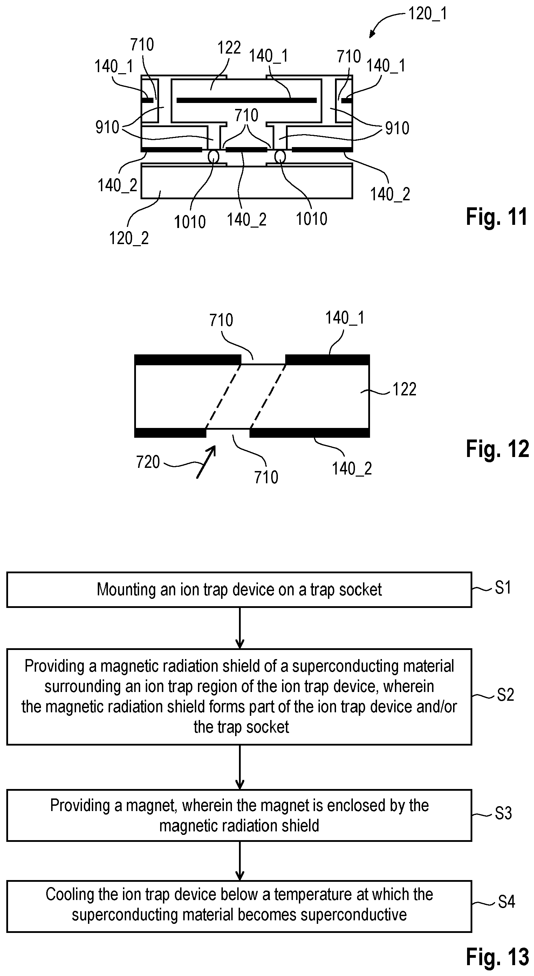

Referring to Figure 11, the magnetic radiation shield 140 may be formed, at least in a region, by a plurality of shield layers 140_1, 140_2 having laterally offset openings 710 in adjacent shield layer 140_1, 140_2. The openings 710 form passages for electrical transmission. In the example shown in Figure 11, the openings 710 allow electrical vias 910 to pass through the magnetic radiation shield layers 140_1, 140_2 at laterally offset locations. That way, magnetic field penetration through the magnetic radiation shield 140 (see Figure 8) is reduced.

As mentioned above, instead of passages for electrical transmissions, the laterally offset openings 710 in adjacent shield layer 140_1, 140_2 may form passages for thermal transmission. In this case, the vias 910 are thermal vias.

In Figure 11 the magnetic radiation shield layers 140_1, 140_2 are exemplified by a surface layer (magnetic radiation shield layer 140_2) and an internal or "buried" layer (magnetic radiation shield layer 140_1) of the first substrate 122. In other examples, two surface layers or exclusively internal layers may be used, for example.

Figure 12 illustrates an example of a passage for optical transmission passing through a multi-layer magnetic radiation shield having shield layers 140_1, 140_2. Again, adjacent shield layers 140_1, 140_2 may have laterally offset openings 710, wherein the openings 710 are configured to form passages for optical transmission (e.g., a laser light beam 720 as illustrated in Figure 7).

In other examples, the magnetic radiation shield 140 (or at least portions thereof) is supported by parts of the trap socket 110, e.g. the frame 110_1 and/or the cover 110_2 or a housing (not shown) forming part of the trap socket 110. In this case, the above disclosure in connection with openings 710 and electrical and/or optical transmissions of Figures 9 to 12 still applies with the exception that the (exemplary) first substrate 122 is replaced by the respective part or structure supporting the magnetic radiation shield 140.

A method of shielding an ion trap device from magnetic radiation may include, at S1 of Figure 13, mounting the ion trap device on a trap socket. As described above, the ion trap device 120 may include an ion trap chip 120_1 mounted on a device carrier 120_2, for example.

At S2 a magnetic radiation shield of a superconducting material is provided to surround an ion trap region of the ion trap device, wherein the magnetic radiation shield forms part of the ion trap device and/or the trap socket. In some examples, where the magnetic radiation shield forms part of the ion trap device alone, S2 is typically carried out prior to S1. That is, the magnetic radiation shield may be pre-assembled on the ion trap device when the trap socket is loaded with the ion trap device. In other examples, in which the magnetic radiation shield forms part of the ion trap device and the trap socket or of the trap socket alone, S2 may be carried out after or during or before S1.

At S3 a magnet is provided, wherein the magnet is enclosed by the magnetic radiation shield. For example, the magnet may be pre-assembled on the ion trap device or may be pre-assembled on the tap socket.

At S4 the ion trap device is cooled down below the temperature at which the superconducting material becomes superconductive. Cooling-down may be performed in a zero magnetic field environment, if possible. For example, the magnet may be activated after cooling the ion trap device below this temperature in order to generate a desired (temporally stable) magnetic field at the ion's position for device operation.

The method may further include providing an ion in the ion trap device. Processes of introducing or generating ions in an ion trap device are known in the art.

The method may further include trapping the ion in the ion trap device by applying electrical signals to the trap electrodes of the ion trap device. The trapped ion may then be processed with laser light for, e.g., performing quantum computing.

## Claims

1. A cryogenic system (100) comprising:
an ion trap device (120) configured to be mounted on a trap socket (110);
a magnetic radiation shield (140) of a superconducting material surrounding an ion trap region of the ion trap device (120), wherein the magnetic radiation shield : (140) forms part of the ion trap device (120) and/or the trap socket (110); and
a magnet (160), wherein the magnet (160) is enclosed by the magnetic radiation shield (140).

2. The cryogenic system (100) of claim 1, wherein the magnetic radiation shield (140) forms part of the ion trap device (120) and does not form part of the trap socket (110).

3. The cryogenic system (100) of claim 1 or 2, wherein the ion trap device (120) comprises a substrate and ion trap electrodes disposed over the substrate, wherein the magnetic radiation shield (140) is at least partly formed as a layer disposed on or integrated in the substrate.

4. The cryogenic system (100) of claim 1, wherein the magnetic radiation shield (140) forms part of the trap socket (110), encloses a first portion of the trap socket (110) and excludes a second portion of the trap socket (110).

5. The cryogenic system (100) of claim 1, wherein the magnetic radiation shield (140) forms part of the trap socket (110) and does not form part of the ion trap device (120).

6. The cryogenic system (100) of claim 1 or 4 or 5, wherein the magnetic radiation shield (140) is at least partly formed as a layer disposed on a part of the trap socket.

7. The cryogenic system (100) of any of the preceding claims, wherein the magnet (160) comprises an electrical coil.

8. The cryogenic system (100) of any of the preceding claims, further comprising electronic circuitry configured to drive the ion trap device (120), wherein the electronic circuitry is external to the magnetic radiation shield (140).

9. The cryogenic system (100) of any of the preceding claims, wherein an opening in the magnetic radiation shield (140) forms a passage for electrical transmission or a passage for optical transmission or a passage for thermal transmission.

10. The cryogenic system (100) of any of the preceding claims, wherein the magnetic radiation shield (140) is formed, at least in a region, by a plurality of shield layers having laterally offset openings in adjacent shield layers, the openings forming a passage for electrical transmission.

11. The cryogenic system (100) of any of the preceding claims, wherein the magnetic radiation shield (140) is formed, at least in a region, by a plurality of shield layers having laterally offset openings in adjacent shield layers, the openings forming a passage for optical transmission.

12. The cryogenic system (100) of any of the preceding claims, wherein the magnetic radiation shield (140) is formed, at least in a region, by a plurality of shield layers having laterally offset openings in adjacent shield layers, the openings forming a passage for thermal transmission.

13. A method of shielding an ion trap device (120) from magnetic radiation, the method comprising:
mounting the ion trap device (120) on a trap socket (110);
providing a magnetic radiation shield (140) of a superconducting material surrounding an ion trap region of the ion trap device (120), wherein the magnetic radiation shield (140) forms part of the ion trap device (120) and/or the trap socket (110);
providing a magnet (160),
wherein the magnet (160) is enclosed by the magnetic radiation shield (140); and
cooling the ion trap device (120) below a temperature at which the superconducting material becomes superconductive.

14. The method of claim 13, further comprising:
activating the magnet (160) after cooling the ion trap device (120) below the temperature.

15. The method of claim 13 or 14, further comprising:
providing an ion in the ion trap device (120);
trapping the ion in the ion trap device (120) by applying electrical signals to trap electrodes of the ion trap device (120); and
processing the ion with laser light.

## Patentansprüche

1. Kryogenes System (100), umfassend:
eine Ionenfallenvorrichtung (120), die dazu konfiguriert ist, an einem Fallensockel (110) montiert zu sein;
eine magnetische Strahlungsabschirmung (140) aus einem supraleitenden Material, die ein Ionenfallengebiet der Ionenfallenvorrichtung (120) umgibt, wobei die magnetische Strahlungsabschirmung: (140) einen Teil der Ionenfallenvorrichtung (120) und/oder des Fallensockels (110) bildet; und
einen Magneten (160), wobei der Magnet (160) von der magnetischen Strahlungsabschirmung (140) umgeben ist.

2. Kryogenes System (100) nach Anspruch 1, wobei die magnetische Strahlungsabschirmung (140) einen Teil der Ionenfallenvorrichtung (120) bildet und keinen Teil des Fallensockels (110) bildet.

3. Kryogenes System (100) nach Anspruch 1 oder 2, wobei die Ionenfallenvorrichtung (120) ein Substrat und Ionenfallenelektroden, die über dem Substrat angeordnet sind, umfasst, wobei die magnetische Strahlungsabschirmung (140) zumindest teilweise als eine Schicht gebildet ist, die auf dem Substrat angeordnet oder in diesem integriert ist.

4. Kryogenes System (100) nach Anspruch 1, wobei die magnetische Strahlungsabschirmung (140) einen Teil des Fallensockels (110) bildet, einen ersten Abschnitt des Fallensockels (110) umschließt und einen zweiten Abschnitt des Fallensockels (110) ausschließt.

5. Kryogenes System (100) nach Anspruch 1, wobei die magnetische Strahlungsabschirmung (140) einen Teil des Fallensockels (110) bildet und keinen Teil der Ionenfallenvorrichtung (120) bildet.

6. Kryogenes System (100) nach Anspruch 1 oder 4 oder 5, wobei die magnetische Strahlungsabschirmung (140) zumindest teilweise als eine Schicht gebildet ist, die auf einem Teil des Fallensockels angeordnet ist.

7. Kryogenes System (100) nach einem der vorhergehenden Ansprüche, wobei der Magnet (160) eine elektrische Spule umfasst.

8. Kryogenes System (100) nach einem der vorhergehenden Ansprüche, das ferner eine elektronische Schaltungsanordnung umfasst, die dazu ausgelegt ist, die Ionenfallenvorrichtung (120) anzusteuern, wobei sich die elektronische Schaltungsanordnung außerhalb der magnetischen Strahlungsabschirmung (140) befindet.

9. Kryogenes System (100) nach einem der vorhergehenden Ansprüche, wobei eine Öffnung in der magnetischen Strahlungsabschirmung (140) einen Durchgang für elektrische Übertragung oder einen Durchgang für optische Übertragung oder einen Durchgang für thermische Übertragung bildet.

10. Kryogenes System (100) nach einem der vorhergehenden Ansprüche, wobei die magnetische Strahlungsabschirmung (140) zumindest in einem Gebiet durch mehrere Abschirmungsschichten mit lateral versetzten Öffnungen in benachbarten Abschirmungsschichten gebildet ist, wobei die Öffnungen einen Durchgang für elektrische Übertragung bilden.

11. Kryogenes System (100) nach einem der vorhergehenden Ansprüche, wobei die magnetische Strahlungsabschirmung (140) zumindest in einem Gebiet durch mehrere Abschirmungsschichten mit lateral versetzten Öffnungen in benachbarten Abschirmungsschichten gebildet ist, wobei die Öffnungen einen Durchgang für optische Übertragung bilden.

12. Kryogenes System (100) nach einem der vorhergehenden Ansprüche, wobei die magnetische Strahlungsabschirmung (140) zumindest in einem Gebiet durch mehrere Abschirmungsschichten mit lateral versetzten Öffnungen in benachbarten Abschirmungsschichten gebildet ist, wobei die Öffnungen einen Durchgang für thermische Übertragung bilden.

13. Verfahren zum Abschirmen einer Ionenfallenvorrichtung (120) vor magnetischer Strahlung, wobei das Verfahren Folgendes umfasst:
Montieren der Ionenfallenvorrichtung (120) an einem Fallensockel (110);
Bereitstellen einer magnetischen Strahlungsabschirmung (140) aus einem supraleitenden Material, das ein Ionenfallengebiet der Ionenfallenvorrichtung (120) umgibt,
wobei die magnetische Strahlungsabschirmung (140) einen Teil der Ionenfallenvorrichtung (120) und/oder des Fallensockels (110) bildet;
Bereitstellen eines Magneten (160), wobei der Magnet (160) von der magnetischen Strahlungsabschirmung (140) umgeben ist; und
Kühlen der Ionenfallenvorrichtung (120) unter eine Temperatur, bei der das supraleitende Material supraleitend wird.

14. Verfahren nach Anspruch 13, das ferner Folgendes umfasst:
Aktivieren des Magneten (160) nach Kühlen der Ionenfallenvorrichtung (120) unter die Temperatur.

15. Verfahren nach Anspruch 13 oder 14, das ferner Folgendes umfasst:
Bereitstellen eines Ions in der Ionenfallenvorrichtung (120);
Einfangen des Ions in der Ionenfallenvorrichtung (120) durch Anlegen elektrischer Signale an Fallenelektroden der Ionenfallenvorrichtung (120); und
Bearbeiten des Ions mit Laserlicht.

## Revendications

1. Système cryogénique (100) comprenant :
un dispositif de piégeage d'ions (120) configuré pour être monté sur une douille de piégeage (110) ;
un écran de protection contre un rayonnement magnétique (140) d'un matériau supraconducteur entourant une zone de piégeage d'ions du dispositif de piégeage d'ions (120), dans lequel l'écran de protection contre un rayonnement magnétique : (140) fait partie du dispositif de piégeage d'ions (120) et/ou de la douille de piégeage (110) ; et
un aimant (160), dans lequel l'aimant (160) est enserré par l'écran de protection contre un rayonnement magnétique (140).

2. Système cryogénique (100) selon la revendication 1, dans lequel l'écran de protection contre un rayonnement magnétique (140) fait partie du dispositif de piégeage d'ions (120) et ne fait pas partie de la douille de piégeage (110).

3. Système cryogénique (100) selon la revendication 1 ou 2, dans lequel le dispositif de piégeage d'ions (120) comprend un substrat et des électrodes de piégeage d'ions disposées sur le substrat, dans lequel l'écran de protection contre un rayonnement magnétique (140) est au moins partiellement formé sous la forme d'une couche disposée sur ou intégrée dans le substrat.

4. Système cryogénique (100) selon la revendication 1, dans lequel l'écran de protection contre un rayonnement magnétique (140) fait partie de la douille de piégeage (110), enserre une première partie de la douille de piégeage (110) et exclut une seconde partie de la douille de piégeage (110).

5. Système cryogénique (100) selon la revendication 1, dans lequel l'écran de protection contre un rayonnement magnétique (140) fait partie de la douille de piégeage (110) et ne fait pas partie du dispositif de piégeage d'ions (120).

6. Système cryogénique (100) selon la revendication 1 ou 4 ou 5, dans lequel l'écran de protection contre un rayonnement magnétique (140) est au moins partiellement formé sous la forme d'une couche disposée sur une partie de la douille de piégeage.

7. Système cryogénique (100) selon l'une quelconque des revendications précédentes, dans lequel l'aimant (160) comprend une bobine électrique.

8. Système cryogénique (100) selon l'une quelconque des revendications précédentes, comprenant en outre un circuit électronique configuré pour entraîner le dispositif de piégeage d'ions (120), dans lequel le circuit électronique est externe à l'écran de protection contre un rayonnement magnétique (140).

9. Système cryogénique (100) selon l'une quelconque des revendications précédentes, dans lequel une ouverture dans l'écran de protection contre un rayonnement magnétique (140) forme un passage pour une transmission électrique ou un passage pour une transmission optique ou un passage pour une transmission thermique.

10. Système cryogénique (100) selon l'une quelconque des revendications précédentes, dans lequel l'écran de protection contre un rayonnement magnétique (140) est formé, au moins dans une zone, par une pluralité de couches d'écran ayant des ouvertures décalées latéralement dans des couches d'écran adjacentes, les ouvertures formant un passage pour une transmission électrique.

11. Système cryogénique (100) selon l'une quelconque des revendications précédentes, dans lequel l'écran de protection contre un rayonnement magnétique (140) est formé, au moins dans une zone, par une pluralité de couches d'écran ayant des ouvertures décalées latéralement dans des couches d'écran adjacentes, les ouvertures formant un passage pour une transmission optique.

12. Système cryogénique (100) selon l'une quelconque des revendications précédentes, dans lequel l'écran de protection contre un rayonnement magnétique (140) est formé, au moins dans une zone, par une pluralité de couches d'écran ayant des ouvertures décalées latéralement dans des couches d'écran adjacentes, les ouvertures formant un passage pour une transmission thermique.

13. Procédé de protection d'un dispositif de piégeage d'ions (120) contre un rayonnement magnétique, le procédé comprenant :
le montage du dispositif de piégeage d'ions (120) sur une douille de piégeage (110) ;
la fourniture d'un écran de protection contre un rayonnement magnétique (140) d'un matériau supraconducteur entourant une zone de piégeage d'ions du dispositif de piégeage d'ions (120), dans laquelle l'écran de protection contre un rayonnement magnétique (140) fait partie du dispositif de piégeage d'ions (120) et/ou de la douille de piégeage (110) ;
la fourniture d'un aimant (160), dans laquelle l'aimant (160) est enserré par l'écran de protection contre un rayonnement magnétique (140) ; et
le refroidissement du dispositif de piégeage d'ions (120) en dessous d'une température à laquelle le matériau supraconducteur devient supraconducteur.

14. Procédé selon la revendication 13, comprenant en outre :
l'activation de l'aimant (160) après refroidissement du dispositif de piégeage d'ions (120) en dessous de la température.

15. Procédé selon la revendication 13 ou 14, comprenant en outre :
la fourniture d'un ion dans le dispositif de piégeage d'ions (120) ;
le piégeage de l'ion dans le dispositif de piégeage d'ions (120) en appliquant des signaux électriques aux électrodes de piégeage du dispositif de piégeage d'ions (120) ; et
le traitement de l'ion par de la lumière laser.
